# EUROPÄISCHE PATENTANMELDUNG

(11) **EP 1 128 484 A2**
(43) Veröffentlichungstag der Anmeldung: **29.08.2001**
(21) Anmeldenummer: 01103916.1
(22) Anmeldetag: 17.02.2001
(51) Int. Cl.: H01R 13/622

(54) **Kupplung oder Stecker für eine Steckverbindung zur Anwendung in der Messtechnik, insbesondere in der Umweltmesstechnik**

(30) Priorität: 25.02.2000 DE 10008885
(71) Anmelder: Endress + Hauser Conducta Gesellschaft für Mess- und Regeltechnik mbH + Co., D-70839 Gerlingen (DE)
(72) Erfinder: Wittmer, Detlev, Dr., 75433 Maulbronn (DE); Babel, Wolfgang, Dr., 71263 Weil der Stadt (DE)
(74) Vertreter: Schäfer, Wolfgang, Dipl.-Ing.

(57) **Zusammenfassung**

Es ist eine Steckverbindung zur Anwendung in der Messtechnik, insbesondere in der Umweltmesstechnik beschrieben. Die Steckverbindung ist mit einer Kupplung (10) und einem Stecker versehen. Ein Gehäuse des Steckers und ein Gehäuse (11) der Kupplung (10) sind an ihren Außenbzw. Innenflächen mit einem Steg (50) und mit einer Nut versehen.

## Beschreibung

Die Erfindung betrifft eine Kupplung oder einen Stecker für eine Steckverbindung zur Anwendung in der Messtechnik, insbesondere in der Umweltmesstechnik, mit einem Kontaktträger, der in einem Gehäuse untergebracht ist. Die Erfindung betrifft ebenfalls eine entsprechende Steckverbindung zur Anwendung in der Messtechnik, insbesondere in der Umweltmesstechnik, mit einer Kupplung und einem Stecker.

Eine derartige Kupplung oder ein derartiger Stecker sind aus der deutschen Patentanmeldung 197 23 684 bekannt. Die dort beschriebene Steckverbindung ist vorzugsweise für den Einsatz in der Mess- und Umwelttechnik vorgesehen. Eine Anforderung an die Steckverbindung besteht darin, dass sie einfach herstellbar, möglichst haltbar und vor allem für einen Benutzer einfach bedienbar sein muss.

Aufgabe der Erfindung ist es, eine Steckverbindung der eingangs genannten Art zu schaffen, die im Hinblick auf die Herstellung, Haltbarkeint und/oder Bedienung weiter verbessert ist.

Diese Aufgabe wird bei einer Kupplung oder einem Stecker der eingangs genannten Art erfindungsgemäß dadurch gelöst, dass das Gehäuse der Kupplung an seiner Innen-, Außen- und/oder Stirnfläche mit einem Vorsprung versehen ist, der einer Ausnehmung in einem Stecker zugeordnet ist, und dass das Gehäuse des Steckers an seiner Außen-, Innen- und/oder Stirnfläche mit einer Ausnehmung versehen ist, die einen Vorsprung einer Kupplung zugeordnet ist.

Durch die Zuordnung des Vorsprungs und der Ausnehmung wird erreicht, dass die Kupplung und der Stecker nur in einer vorgegebenen Drehposition miteinander verbunden werden können. Dies gewährleistet die korrekte Justierung der einzelnen Kontakte der Kupplung und des Steckers zueinander. Die Bedienung der Steckverbindung wird dadurch für den Benutzer wesentlich vereinfacht.

Durch die Ausbildung des Vorsprungs und der Ausnehmung an den Gehäusen der Kupplung und des Steckers wird erreicht, dass beim Einführen der beiden Bauteile ineinander gegebenenfalls auftretende Beanspruchungen keinerlei negativen Einfluss auf die strom- bzw. spannungsführenden Bauteile der Steckverbindung haben können. Stattdessen wirken die Beanspruchungen nur auf die beiden Gehäuse, was zu keinen Beeinträchtigungen der elektrischen Eigenschaften der Steckverbindung führen kann. Dies erhöht die Haltbarkeit des erfindungsgemäßen Steckers bzw. der erfindungsgemäßen Kupplung.

Außerdem können der Vorsprung und die Ausnehmung besonders einfach und kostengünstig hergestellt werden, so dass auch insoweit eine Verbesserung bei der erfindungsgemäßen Steckverbindung erreicht wird.

Besonders vorteilhaft ist es, wenn das Gehäuse aus einem harten Kunststoff hergestellt ist, insbesondere aus Polyphenylensulfid (PPS). Damit wird erreicht, dass jegliche Beanspruchungen durch den harten Kunststoff des Gehäuses aufgenommen und kompensiert werden. Insbesondere Druck- oder Scherkräfte, die beim Einführen des Vorsprungs in die Ausnehmung entstehen können, haben aufgrund des harten Kunststoffs keinerlei negative Auswirkungen auf die Steckverbindung. Insbesondere ist dadurch gewährleistet, dass die elektrischen Eigenschaften der Steckverbindung in jedem Fall unverändert erhalten bleiben.

Weiterhin ist es besonders vorteilhaft, wenn der Kontaktträger aus einem elektrisch isolierenden und elastischen Kunststoff, insbesondere aus Polyfluoralkoxypolymer (PFA) besteht. Auch wenn dieser Kunststoff nicht besonders hart ist, so hat dies nicht zur Folge, dass die Kontaktträger insbesondere beim Zusammenfügen der Kupplung und des Steckers irgendwelchen Beeinträchtigungen ausgesetzt sind. Durch die Anordnung des Vorsprungs und der Ausnehmung an den Gehäusen der Kupplung und des Steckers werden jegliche Beanspruchungen - wie erwähnt - von den Gehäusen aufgenommen und haben damit keinen Einfluss auf die Kontaktträger.

Besonders vorteilhaft ist es, wenn als Vorsprung ein Steg und als Ausnehmung eine Nut vorgesehen sind, die aneinander angepasst sind. Es versteht sich, dass der Steg und die Nut beliebig dem Stecker oder der Kupplung, wie auch den Außen- oder Innenflächen dieser Bauteile zugeordnet werden können.

Bei einer vorteilhaften Weiterbildung der Erfindung sind die Kontaktträger zusätzlich mit einem weiteren Steg und mit einer weiteren Nut versehen. Damit wird eine weitere Justierung der Kontakte des Steckers und der Kupplung zueinander erreicht. Es versteht sich, dass der Steg und die Nut beliebig den Kontaktträgern der Kupplung und des Steckers zugeordnet werden können.

Besonders vorteilhaft ist es, wenn die Stege und die Nuten in den Gehäusen und in den Kontaktträgern derart ausgebildet sind, dass zuerst der Steg und die Nut der Gehäuse ineinander eingreifen, und erst danach der Steg und die Nut der Kontaktträger ineinander eingreifen. Dies gewährleistet, dass die eigentliche Justierung der Kontakte der Kupplung und des Steckers durch den Steg und die Nut der Gehäuse erfolgt und nicht durch den Steg und die Nut der Kontaktträger. Damit wird gewährleistet, dass die Kontaktträger durch ein inkorrektes Einführen des Stekcers in die Kupplung nicht in Mitleidenschaft gezogen werden. Erst nach der Justierung durch den Steg und die Nut der Gehäuse können der Steg und die Nut der Kontaktträger ineinander eingeführt werden. Dabei sind der Steg und die Nut der Kontaktträger schon automatisch durch den Steg und die Nut der Gehäuse korrekt zueinander ausgerichtet.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.
- Figur 1: zeigt eine schematische Perspektivdarstellung eines Ausführungsbeispiels einer erfindungsgemäßen Kupplung,
- Figur 2: zeigt eine schematische Schnittdarstellung durch die Kupplung der Figur 1,
- Figur 3: zeigt eine schematische Perspektivdarstellung eines Ausführungsbeispiels eines erfindungsgemäßen Steckers, und
- Figur 4: zeigt eine schematische Schnittdarstellung durch den Stecker der Figur 3.

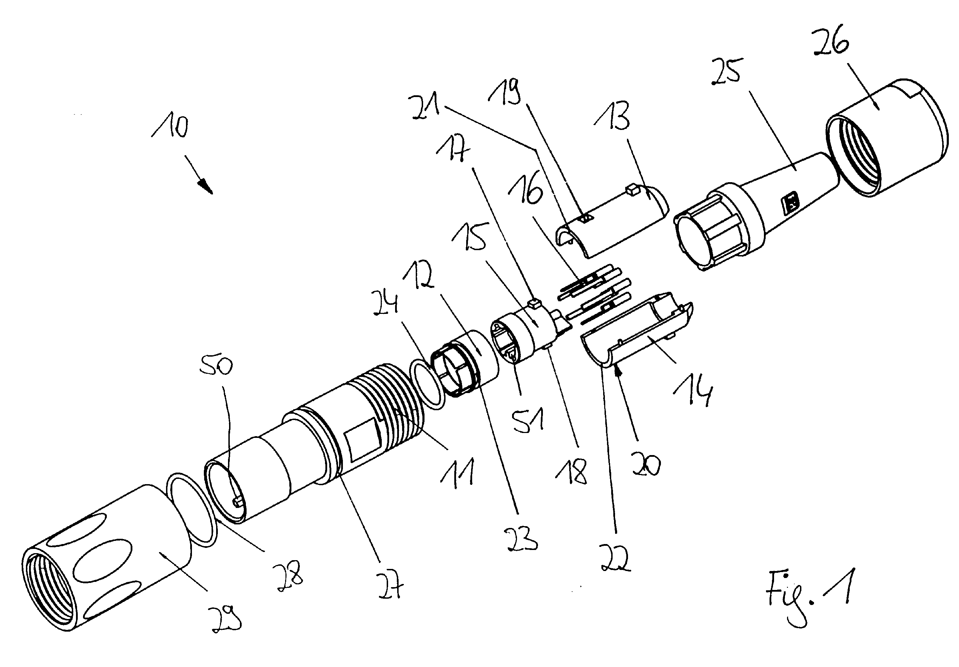

In den Figuren 1 bis 4 ist eine Steckverbindung dargestellt, die aus einer Kupplung 10 und einem Stecker 30 zusammengesetzt werden kann. Die Steckverbindung ist flüssigkeitsdicht ausgestaltet und kann bspw. in der Messtechnik, insbesondere in der Umweltmesstechnik eingesetzt werden. Es versteht sich, dass die nachfolgend beschriebene Steckverbindung auch unabhängig von der vorstehend genannten Flüssigkeitsdichtigkeit eingesetzt werden kann.

Mit der Steckverbindung kann bspw. ein Kabel an einen Sensor angeschlossen werden. Dabei wird das Kabel an die Kupplung 10 und der Sensor an den Stecker 30 angeschlossen. Es versteht sich, dass die nachfolgend beschriebenen Merkmale des Steckers 30 auch bei einer Kupplung vorgesehen werden können. Entsprechend können die nachfolgend beschriebenen Merkmale der Kupplung 10 auch bei einem Stecker eingesetzt werden. Insoweit kann die Steckverbindung auch dazu vorgesehen sein, zwei Kabel miteinander zu verbinden. Ebenfalls ist es möglich, dass ein Sensor an den Stecker und ein Kabel an die Kupplung angeschlossen werden kann.

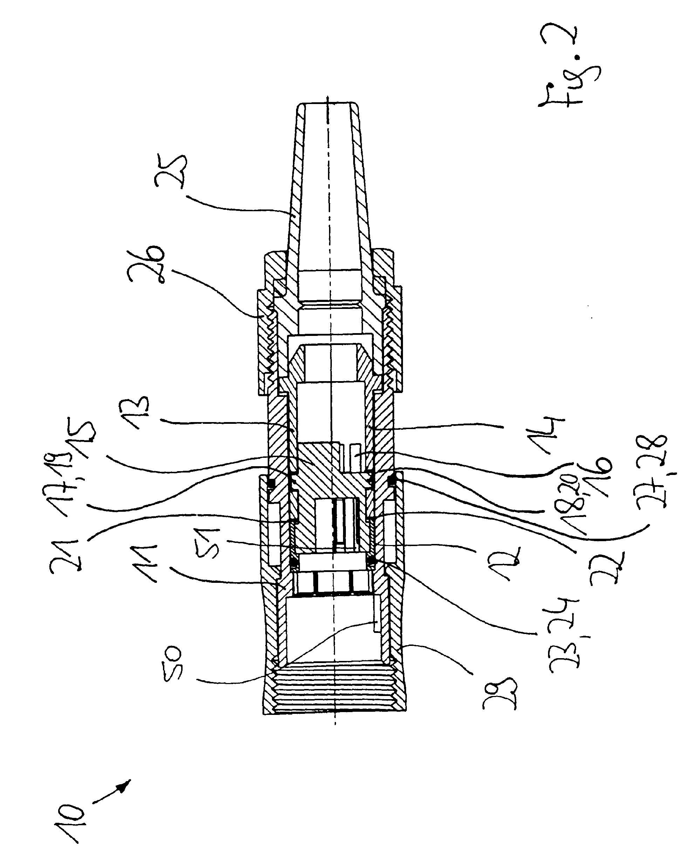

Die Kupplung 10 ist in den Figuren 1 und 2 dargestellt. Die Kupplung 10 ist dazu vorgesehen, dass ein Kabel an sie angeschlossen wird. Die Kupplung 10 ist im Wesentlichen rotationssymmetrisch ausgebildet.

Die Kupplung 10 weist ein Gehäuse 11 auf, in dem eine Abschirmung untergebracht ist. Das Gehäuse 11 ist aus einem harten Kunststoff hergestellt, beispielsweise aus Polyphenylensulfid (PPS). Die Abschirmung setzt sich aus einer Hülse 12 und aus zwei Halbschalen 13, 14 zusammen. In die Hülse 12 ist ein Kontaktträger 15 eingesetzt. In dem Kontaktträger 15 sind Kontaktstifte 16 aufgenommen.

Die Hülse 12 und der Kontaktträger 15 sind im Wesentlichen rohrförmig ausgebildet. Der Innendurchmesser der Hülse 12 entspricht etwa dem Außendurchmesser des Kontaktträgers 15. Die Hülse 12 ist aus elektrisch leitfähigem Metall hergestellt. Der Kontaktträger 15 besteht aus einem elektrisch isolierenden und elastischen Kunststoff, beispielsweise aus Polyfluoralkoxypolymer (PFA). Im eingesetzten und verpressten Zustand liegen der Kontaktträger 15 und die Hülse 12 dicht aneinander an. Auf Grund des verwendeten elastischen Kunststoffs entsteht dadurch eine flüssigkeitsdichte Verbindung zwischen der Hülse 12 und dem Kontaktträger 15.

Von dem Kontaktträger 15 stehen auf einander gegenüberliegenden Seiten zwei Vorsprünge 17, 18 ab. In den Halbschalen 13, 14 ist jeweils eine Öffnung 19, 20 eingebracht, die den Vorsprüngen 17, 18 zugeordnet sind. Die Halbschalen 13, 14 besitzen einen Innenradius, der dem Außenradius des Kontaktträgers 15 entspricht. Damit können die Halbschalen 13, 14 auf den Kontaktträger 15 aufgelegt werden. Die Vorsprünge 17, 18 des Kontaktträgers 15 greifen dabei in die Ausnehmungen 19, 20 der Halbschalen 13, 14 ein. Auf diese Weise besteht eine mechanische Verbindung zwischen dem Kontaktträger 15 und den Halbschalen 13, 14.

Die Halbschalen 13, 14 sind bspw. als Spritzgußteile aus Kunststoff hergestellt. Zumindest eine der Flächen der Halbschalen 13, 14, bspw. die Außenflächen sind mit einer elektrisch leitfähigen Schicht versehen. Ebenfalls sind die der Hülse 12 zugewandten Stirnflächen 21, 22 der Halbschalen 13, 14 mit einer elektrisch leitfähigen Schicht versehen.

Im zusammengesetzten Zustand der Abschirmung, also wenn der Kontaktträger 15 in die Hülse 12 eingesetzt ist, und wenn die Halbschalen 13, 14 auf den Kontakttäger 15 aufgesetzt sind, liegen die Stirnflächen 21, 22 der Halbschalen 13, 14 an der Hülse 12 an. Auf diese Weise entsteht eine elektrische Verbindung zwischen der metallischen Hülse 12 und den mit der elektrisch leitfähigen Schicht versehenen Halbschalen 13, 14.

Die aus der Hülse 12 und den Halbschalen 13, 14 bestehende Abschirmung einschließlich des darin untergebrachten Kontaktträgers 15 ist in dem Gehäuse 11 aufgenommen. Auf der Außenfläche der Hülse 12 ist eine Nut 23 vorgesehen, in die eine Ringdichtung 24 eingesetzt ist. Die Ringdichtung 24 liegt andererseits an der Innenfläche des Gehäuse 11 an. Damit besteht eine flüssigkeitsdichte Verbindung zwischen der Hülse 12 und dem Gehäuse 11.

Mit ihrem der Hülse 15 abgewandten freien Ende sind die Halbschalen 13, 14 in eine im Wesentlichen rohrförmige Kabeltülle 25 eingesteckt. Über die Kabeltülle 25 ist eine Mutter 26 aufgesteckt, die mit dem Gehäuse 11 verschraubt werden kann. Damit ist die aus der Hülse 12 und den Halbschalen 13 und 14 bestehende Abschirmung einschließlich des darin untergebrachten Kontaktträgers 15 fest und flüssigkeitsdicht im Innenraum des Gehäuses 11 untergebracht.

Auf seiner Außenfläche ist das Gehäuse 11 mit einer Ringnut 27 versehen, in die eine Ringdichtung 28 eingesetzt ist. Auf das Gehäuse 11, und zwar über die Ringdichtung 28, ist eine Verschraubung 29 aufgesteckt, mit der die Kupplung 10 mit dem Stecker 30 verschraubt werden kann. Die Ringdichtung 28 verhindert das Einlagern von Verschmutzungen in den Ringspalt zwischen dem Gehäuse 11 und der Verschraubung 29.

Auf seiner Innenfläche ist das Gehäuse 11 mit einem Steg. 50 versehen. Der Steg 50 steht als länglicher Vorsprung von der Innenfläche des Gehäuses 11 ab und besitzt einen etwa rechteckförmigen Querschnitt. Der Steg 50 ist mit seiner Längsachse parallel zur Längsachse der Kupplung 10 ausgerichtet. Der Steg 50 ist im Bereich desjenigen Endes des Gehäuses 11 angeordnet, das der Kabeltülle 25 abgewandt ist. Der Steg 50 reicht jedoch nicht ganz bis zu dem genannten Ende des Gehäuses 11. Die Anordnung des Stegs 50 ist insbesondere aus der Figur 1 ersichtlich.

Der Steg 50 kann auch als nasenförmiger Vorsprung und damit ohne eine Ausdehnung in Längsrichtung ausgebildet sein.

Zusätzlich ist es möglich, dass auch die Innenfläche des Kontaktträgers 15 mit einem vorstehenden Steg 51 versehen ist. Der Steg 51 ist dann in Längsrichtung der Kupplung 10 ausgerichtet, mit einem etwa rechteckförmigen Querschnitt versehen und an dem der Kabeltülle 25 abgewandten Ende des Kontaktträgers 15 angeordnet. Der Steg 51 kann auch nasenförmig ausgebildet sein.

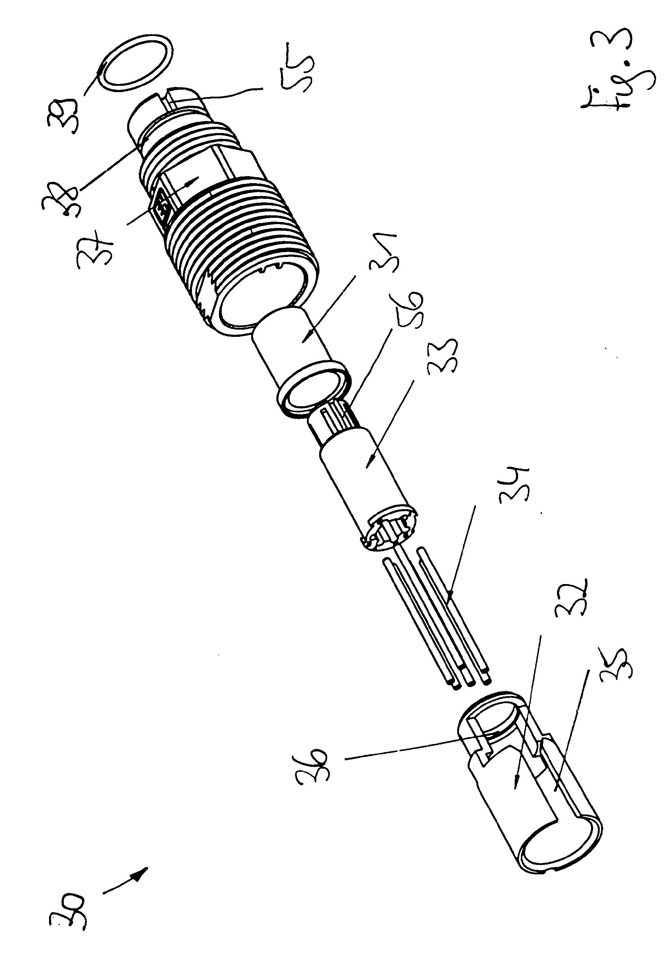

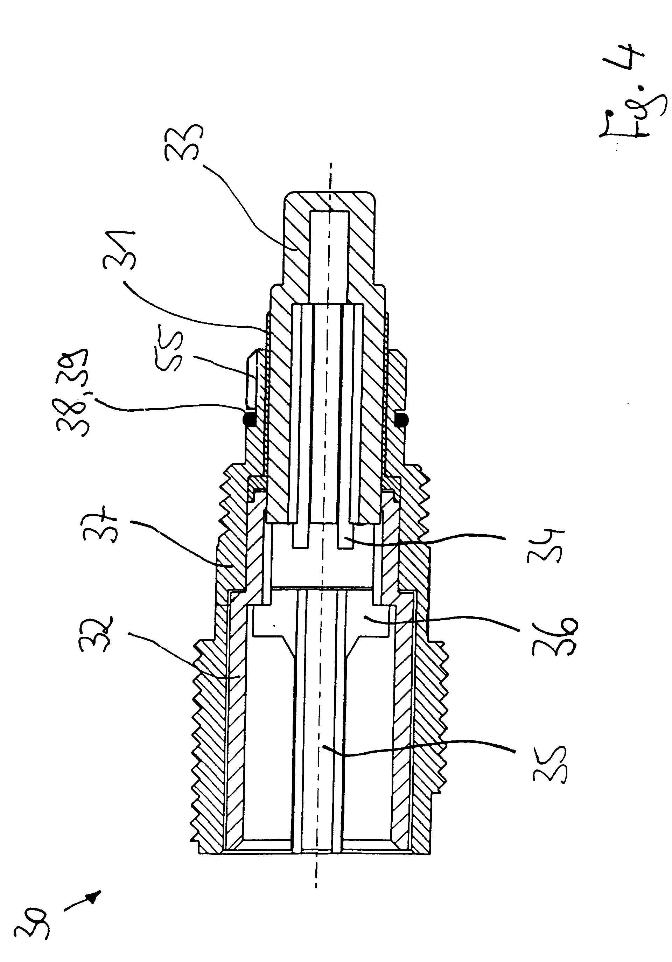

In den Figuren 3 und 4 ist der Stecker 30 dargestellt. Der Stecker 30 ist dazu vorgesehen, mit einem Sensor o.dgl. verbunden zu werden. Der Stecker 30 ist im Wesentlichen rotationssymmetrisch ausgebildet.

Der Stecker 30 weist eine Abschirmung auf, die aus einer ersten Hülse 31 und einer zweiten Hülse 32 besteht. Die erste Hülse 31 besitzt an ihrem der zweiten Hülse 32 zugewandten freien Ende einen Innendurchmesser, der dem Außendurchmesser des zugewandten freien Endes der zweiten Hülse 32 entspricht. Die erste Hülse 31 und die zweite Hülse 32 sind an diesen, einander zugewandten freien Enden miteinander verpresst. Es besteht somit eine feste mechanische Verbindung zwischen der ersten Hülse 31 und der zweiten Hülse 32.

Die erste Hülse 31 ist rohrförmig ausgebildet. Im Inneren der ersten Hülse 31 ist ein Kontaktträger 33 angeordnet. Der Kontaktträger 33 dient der Aufnahme von Kontaktstiften 34.

Die erste Hülse 31 ist bspw. als Drehteil aus einem elektrisch leitfähigen Metall hergestellt. Die zweite Hülse 32 ist als Spritzgußteil aus Kunststoff hergestellt. Die Außenfläche der zweiten Hülse 32 ist mit einer elektrisch leitfähigen Schicht versehen. Die zweite Hülse 32 weist einen in Längsrichtung ausgerichteten Schlitz 35 auf. Des Weiteren ist die zweite Hülse 32 mit zumindest einem Fenster 36 versehen.

Durch die Verpressung der ersten Hülse 31 mit der zweiten Hülse 32 sind die genannten beiden Hülsen 31, 32 elektrisch miteinander verbunden. Daraus ergibt sich insgesamt die bereits erwähnte Abschirmung.

Der Kontaktträger 33 ist aus einem elektrisch isolierenden und elastischen Kunststoff, z.B. aus Polyfluoralkoxypolymer (PFA) hergestellt. Der Außendurchmesser des Kontaktträgers 33 entspricht etwa dem Innendurchmesser der ersten Hülse 31. Damit liegt der Kontaktträger 33 an der ersten Hülse 31 dicht an. Auf Grund des verwendeten elastischen Kunststoffs entsteht somit eine flüssigkeitsdichte Verbindung zwischen dem Kontaktträger 33 und der ersten Hülse 31.

Der Längsschlitz 35 ist zur Verbindung der Kupplung 30 mit dem genannten Sensor vorgesehen. Bspw. ist es möglich, dass ein Glasrohr des Sensors in die Hülse 32 eingesteckt wird. Der Schlitz 35 erlaubt einen Ausgleich von Durchmessertoleranzen des Glasrohrs, um eine sichere Klemmung zu gewährleisten. Alternativ oder zusätzlich kann das Glasrohr des Sensors mit der Hülse 32 verklebt werden, wobei der Schlitz 35 dann die Befüllung mit Klebstoff erlaubt.

Das Fenster 36 in der Hülse 32 ist dazu vorgesehen, dass die Leitungen des Sensors mit den Kontaktstiften 34 des Kontaktträgers 33 elektrisch verbunden werden können. Zu diesem Zweck ist es möglich, dass die Leitungen des Sensors durch das bzw. die Fenster 36 hindurch an die Kontaktstifte 34 angelötet werden.

Die aus der ersten Hülse 31 und der zweiten Hülse 32 bestehende Abschirmung einschließlich des darin untergebrachten Kontaktträgers 33 ist in einem Gehäuse 37 untergebracht. Das Gehäuse 37 ist aus einem harten Kunststoff hergestellt, beispielsweise aus Polyphenylensulfid (PPS). Auf der der zweiten Hülse 32 abgewandten Außenfläche des Gehäuses 37 ist eine Ringnut 38 vorgesehen, in die eine Ringdichtung 39 eingesetzt ist.

Auf der Außenfläche des Gehäuses 37 ist eine Nut 55 vorhanden. Die Nut 55 ist in Längsrichtung des Steckers 30 ausgerichtet. Die Nut 55 erstreckt sich von dem der zweiten Hülse 32 abgewandten Ende des Gehäuses 37 bis zu der Ringnut 38 für die Ringdichtung 39. Der Querschnitt der Nut 55 entspricht dem Querschnitt des Stegs 50. Entsprechendes gilt für die Länge der Nut 55. Die Anordnung der Nut 55 ist insbesondere aus der Figur 3 ersichtlich.

Damit kann die Kupplung 10 mit dem Steg 50 in die Nut 55 des Steckers 30 eingeführt werden. Der Steg 50 reicht dabei nur bis zu der in der Ringnut 38 befindlichen Ringdichtung 39, so dass die diesbezügliche Abdichtung durch die Steg/Nut-Verbindung nicht beeinflusst wird.

Zusätzlich ist es möglich, dass die Außenfläche des Kontaktträgers 33 mit einer Nut 56 versehen ist. Die Nut 56 ist in Längsrichtung des Steckers 30 ausgerichtet und im Hinblick auf ihren Querschnitt und ihre Länge an den Steg 51 angepasst.

Damit kann die Kupplung 10 mit dem Steg 51 in die Nut 56 des Steckers 30 eingeführt werden. Dabei kann durch die Anordnung der Stege 50, 51 und der Nuten 55, 56 vorgesehen sein, dass zuerst der Steg 50 in die Nut 55 eingreift und erst danach der Steg 51 in die Nut 56 eingreifen kann. Dies hat dann zur Folge, dass durch den von einer Bedienperson in die Nut 55 eingeführten Steg 50 eine Justierung der Kupplung 10 und des Steckers 30 zueinander erfolgt, so dass der Steg 51 aufgrund der bereits vorhandenen Justierung automatisch in die Nut 56 eingeführt wird.

Das Gehäuse 37 ist mit einem Außengewinde versehen, auf das die Verschraubung 29 des Steckers 10 aufgeschraubt werden kann. Die Verschraubung 29 ist im aufgeschraubten Zustand über der Ringdichtung 39 angeordnet. Auf diese Weise entsteht eine flüssigkeitsdichte Verbindung zwischen der Verschraubung 29 und dem Gehäuse 37.

Die Herstellung der Kupplung 10 erfolgt bspw. wie folgt:

Zuerst werden die Kontaktstifte 16 in den Kontaktträger 15 eingesteckt und der Kontaktträger 15 in die Hülse 12 eingepresst. Dann wird das anzuschließende Kabel durch die Kabeltülle 25 und die Mutter 26 hindurchgesteckt. Nunmehr können die Leitungen des anzuschließenden Kabels an die Kontaktstifte 16 angelötet werden. Des Weiteren werden die Halbschalen 13, 14 auf den Kontaktträger 15 aufgelegt. Der Kontaktträger 15 zusammen mit den Anschlussstiften 16 und den daran angelöteten Leitungen des anzuschließenden Kabels befinden sich damit innerhalb der aus der Hülse 12 und den Halbschalen 13, 14 bestehenden Abschirmung. Diese Abschirmung wird nunmehr einerseits mit den freien Enden der Halbschalen 13, 14 in die Kabeltülle 25 eingesteckt, sowie andererseits mit der Hülse 12 in das Gehäuse 11 eingeschoben. Zuvor wird der Dichtring 24 auf die Hülse 12 aufgezogen. Die Mutter 26 wird nunmehr auf das Außengewinde des Gehäuses 11 aufgeschraubt. Schließlich wird die Ringdichtung 28 in die Ringnut 27 eingesetzt und es wird die Verschraubung 29 auf das Gehäuse 11 aufgesteckt.

Die Herstellung des Steckers 30 erfolgt bspw. wie folgt:

Zuerst werden die Kontaktstifte 34 in den Kontaktträger 33 eingesetzt. Dann wird der Kontaktträger 33 in die erste Hülse 31 eingesetzt. Daraufhin wird die erste Hülse 31 mit der zweiten Hülse 32 verpresst. Es kann nunmehr der vorgesehene Sensor in die zweite Hülse 32 eingesetzt werden. Die Anschlussleitungen des eingesetzten Sensors können durch die Fenster 36 der zweiten Hülse 32 hindurch mit den Kontaktstiften 34 verlötet werden. Nunmehr wird die aus der ersten und der zweite Hülse 31, 32 bestehende Abschirmung einschließlich des darin untergebrachten Kontaktträgers 33 mit den Kontaktstiften 34 und den angelöteten Anschlussleitungen des Sensors in das Gehäuse 37 eingeschoben und ggf. verklebt. Die Ringdichtung 39 wird in die Ringnut 38 des Gehäuses 37 eingesetzt.

Zur Verbindung des Steckers 30 und der Kupplung 10 wird das freie Ende des Steckers 30 mit der Ringdichtung 39 in die Verschraubung 29 der Kupplung 10 eingesteckt. Dabei wird der Steg 50 der Kupplung 10 von der Bedienperson zu der Nut 55 des Steckers 30 ausgerichtet und dann in dieselbe eingeführt. Sofern vorhanden, wird auch der Steg 51 der Kupplung 10 in die Nut 56 des Steckers 30 eingeführt. Dies kann aufgrund der bereits vorhandenen Justierung durch den Steg 50 in der Nut 55 ohne eine weitere Justierung durch die Bedienperson erfolgen. Daraufhin wird der Stecker 30 und die Kupplung 10 mittels der Verschraubung 29 miteinander verschraubt.

In einer abweichenden Ausführungsform ist es möglich, anstelle des Stegs 50 un der Nut 55 einen Vorsprung an der Stirnfläche des Gehäuses 11 der Kupplung 10 vorzusehen, der einer Ausnehmung an der Stirnfläche des Gehäuses 37 des Steckers 30 zugeordnet ist. Es versteht sich, dass der Vorsprung und die Ausnehmung auch umgekehrt an dem Stecker 30 und der Kupplung 10 ausgebildet sein können.

## Patentansprüche

1. Kupplung (10) für eine Steckverbindung zur Anwendung in der Messtechnik, insbesondere in der Umweltmesstechnik, mit einem Kontaktträger (15), der in einem Gehäuse (11) untergebracht ist, dadurch gekennzeichnet, dass das Gehäuse (11) an seiner Innen-, Außen- und/oder Stirnfläche mit einem Vorsprung versehen ist, der einer Ausnehmung in einem Stecker zugeordnet ist.

2. Stecker (30) für eine Steckverbindung zur Anwendung in der Messtechnik, insbesondere in der Umweltmesstechnik, mit einem Kontaktträger (33), der in einem Gehäuse (37) untergebracht ist, dadurch gekennzeichnet, dass das Gehäuse (37) an seiner Außen-, Innen- und/oder Stirnfläche mit einer Ausnehmung versehen ist, die einen Vorsprung einer Kupplung zugeordnet ist.

3. Kupplung (10) oder Stecker (30) nach einem der Ansprüche 1 oder 2, dadurch gekennzeichnet, dass das Gehäuse (11, 37) aus einem harten Kunststoff hergestellt ist, insbesondere aus Polyphenylensulfid (PPS).

4. Kupplung (10) oder Stecker (30) nach einem der Ansprüche 1 bis 3, dadurch gekennzeichnet, dass der Kontaktträger (15, 33) aus einem elektrisch isolierenden und elastischen Kunststoff, insbesondere aus Polyfluoralkoxypolymer (PFA) besteht.

5. Kupplung (10) oder Stecker (30) nach einem der Ansprüche 1 bis 4, dadurch gekennzeichnet, dass ein Steg (50) und eine Nut (55) vorgesehen sind, die aneinander angepasst sind.

6. Kupplung (10) oder Stecker (30) nach einem der Ansprüche 1 bis 5, dadurch gekennzeichnet, dass die Kontaktträger (15, 33) zusätzlich mit einem weiteren Steg (51) und mit einer weiteren Nut (56) versehen sind.

7. Kupplung (10) oder Stecker (30) nach Anspruch 6, dadurch gekennzeichnet, dass der weitere Steg (51) und die weitere Nut (56) aneinander angepasst sind.

8. Kupplung (10) oder Stecker (30) nach einem der Ansprüche 1 bis 7, dadurch gekennzeichnet, dass der Vorsprung bzw. der Steg (50) bzw. die Stege (50, 51) und die Ausnehmung bzw. die Nut (55) bzw. die Nuten (55, 56) in Längsrichtung ausgerichtet sind.

9. Steckverbindung zur Anwendung in der Messtechnik, insbesondere in der Umweltmesstechnik, mit einer Kupplung (10) und einem Stecker (30), dadurch gekennzeichnet, dass ein Gehäuse (37) des Steckers (30) und ein Gehäuse (11) der Kupplung (10) an ihren Außen- bzw. Innen- bzw. Stirnflächen mit einem Vorsprung und mit einer Ausnehmung versehen sind.

10. Steckverbindung nach Anspruch 9, dadurch gekennzeichnet, dass ein Steg (50) und eine Nut (55) vorgesehen sind, die aneinander angepasst sind.

11. Steckverbindung nach einem der Ansprüche 9 oder 10, dadurch gekennzeichnet, dass ein Kontaktträger (33) des Steckers (30) und ein Kontaktträger (15) der Kupplung (10) mit einem weiteren Steg (51) und mit einer weiteren Nut (56) versehen sind.

12. Steckverbindung nach einem der Ansprüche 9 bis 11, dadurch gekennzeichnet, dass das Gehäuse (11, 37) aus einem harten Kunststoff hergestellt ist, insbesondere aus Polyphenylensulfid (PPS).

13. Steckverbindung nach einem der Ansprüche 9 bis 12, dadurch gekennzeichnet, dass der Kontaktträger (15, 33) aus einem elektrisch isolierenden und elastischen Kunststoff, insbesondere aus Polyfluoralkoxypolymer (PFA) besteht.
